# EUROPEAN PATENT APPLICATION

(11) **EP 4 648 286 A1**
(43) Date of publication of application: **12.11.2025**
(21) Application number: 24175036.3
(22) Date of filing: 09.05.2024
(51) Int. Cl.: H03K 17/72, H03K 17/06, H03K 17/12

(54) **ELECTRIC CIRCUITS AND TRIGGERING DETECTION METHODS FOR ELECTRIC CIRCUITS**

(71) Applicant: GE Energy Power Conversion Technology Ltd, Rugby, Warwickshire CV21 1BD (GB)
(72) Inventor: Geske, Martin, 12277 Berlin (DE); Biebrach, Kai, 12277 Berlin (DE); Obremba, Jens, 12277 Berlin (DE)
(74) Representative: Serjeants LLP

(57) **Abstract**

An electric circuit is described. The electric circuit may be part of a power converter and may include a plurality of electrically connected thyristors (Ta, Tb, ..., Tn). Each thyristor (Ta, Tb, ..., Tn) has a gate terminal (26a, 26b, ..., 26n) electrically connected to a gate drive unit (28a, 28b, ..., 28n) adapted to generate gate pulses for triggering the thyristor. At least one of the plurality of gate drive units (26a, 26b, ..., 26n) is adapted to measure the gate voltage of the respective thyristor (Ta, Tb, ..., Tn) after one or more gate pulses have been applied to the respective thyristor. The measured gate voltage may be used to determine if a thyristor has not been triggered by the gate pulse(s) - e.g., if the gate voltage is below a voltage threshold.

## Description

### Technical Field

The present invention relates to electric circuits, and in particular to electric circuits that comprise a plurality of electrically connected thyristors. The electric circuit may form part of a power converter, for example, where the thyristors are triggered to turn on by applying one or more gate pulses.

The present invention is particularly applicable for thyristors that are electrically connected in parallel.

The present invention also relates to a triggering detection method for an electric circuit that may be used to detect if a thyristor has not been properly triggered to turn on after the one or more gate pulses have been applied.

### Background Art

Thyristors are known and include three terminals, namely an anode terminal, a cathode terminal, and a gate terminal (or control terminal). When the cathode terminal is negatively charged relative to the anode terminal, no current flows through the thyristor until one or more gate pulses are applied to the gate terminal. The thyristor is triggered (or turned on) if the one or more gate pulses have a gate voltage that exceeds the gate trigger voltage of the thyristor and a gate current that exceeds the gate trigger current of the thyristor. Each gate pulse will have a particular pulse duration.

After being triggered, the thyristor will continue to conduct current until the voltage between the cathode and anode is reversed or reduced below a certain threshold or holding value.

When thyristors are electrically connected in parallel it may be difficult to detect if a particular thyristor has been triggered properly. The voltage across all parallel-connected thyristors breaks down once the first thyristor is turned on. It is known to monitor non-parallel connected thyristors using the anode-to-cathode voltage, but this is not suitable for parallel-connected thyristors.

Known ways of monitoring parallel-connected thyristors include using temperature sensors, which may provide delayed feedback (e.g., up to a few seconds) because of thermal constraints. Current sensors can be used to detect if a current is flowing through each thyristor, but this results to increased costs and circuit complexity.

The present invention aims to provide simple and robust monitoring of electrically connected thyristors that is faster than relying on temperature sensors, for example. The present invention avoids the need for current sensors.

It also provides fast detection and protection in the case of non-triggering or failed thyristors.

### Summary of the invention

The present invention provides an electric circuit comprising:
a plurality of electrically connected thyristors, each thyristor having a gate terminal electrically connected to a respective gate drive unit adapted to generate gate pulses for triggering the thyristor;
wherein at least one of the plurality of gate drive units is adapted to measure the gate voltage of the respective thyristor after one or more gate pulses have been applied to the gate terminal of the respective thyristor.

Each gate drive unit may be adapted to measure the gate voltage of the respective thyristor after one or more gate pulses have been applied to the gate terminal of the respective thyristor. In other words, the gate voltages of all of the thyristors of the electric circuit are preferably measured.

The gate voltage of each thyristor may be measured using a voltage sensor. The voltage sensor may be part of, or associated with, the gate drive unit for the respective thyristor.

Any suitable voltage sensor may be used. The voltage sensor may include an analog-to-digital converter (or ADC) and a programmable logic device or microcontroller unit, for example. Each gate drive unit may also include a respective configurable integrated circuit, e.g., a field-programmable gate array or FGPA. For example, the gate terminal of each thyristor may be electrically connected to a respective gate drive unit that includes a voltage sensor for measuring the gate voltage and a configurable integrated circuit. In other respects, the gate drive units may have any suitable known construction for generating the gate pulses.

The gate drive units may be controlled by a controller (e.g., a converter controller) and may receive control signals from the controller for generating the gate pulses. In particular, the control signals may be used by each gate drive unit to determine the start of each gate pulse that is applied to the respective thyristor. The control signals may also be used by each gate drive unit to determine the duration of each gate pulse. The controller may receive gate voltage measurement signals from the gate drive units. The control signals and the gate voltage measurement signals may be transmitted using any suitable protocol.

Each gate pulse generated by each gate drive unit may have a gate voltage that exceeds the gate trigger voltage of the respective thyristor, and a gate current that exceeds the gate trigger current of the respective thyristor. Each gate pulse may have a gate pulse duration.

The electric circuit may form part of a power converter or a crowbar circuit, for example.

The thyristors may typically be electrically connected in parallel, but they may also be electrically connected in series. The thyristors of the electric circuit may often be the same, but in some cases the thyristors may be different.

Two or more gate pulses may be applied to each thyristor before the gate voltage is measured. For example, the gate voltage of each thyristor may be measured by the respective gate drive unit after a final gate pulse of a series of two or more gate pulses has been generated by the gate drive unit and applied to the thyristor.

Each gate drive unit may be adapted to measure the gate voltage of the respective thyristor after a period of time has elapsed following the end of an applied gate pulse. In other words, after a gate pulse has ended, and the gate current has returned to zero, there may be a deliberate delay (referred to below as a "delay time") before the gate voltage is measured. The period of time after the end of the applied gate pulse (i.e., the delay before the first gate voltage measurement is taken) may be at least about 1 µs, for example. In some examples, the period of time after the end of the applied gate pulse before the first gate voltage measurement is taken may be at least about 5 µs, at least about 10 µs or at least about 100 µs. The gate voltage normally experiences transient behaviour at the start and end of the gate pulse and the delay allows the gate voltage to stabilise before it is measured. After the delay, one or more measurements of the gate voltage may be taken. The delay between the end of the gate pulse and the time when the gate voltage is first measured may be considered in terms of a period of time (referred to below as a "blanking time") during which the gate voltage is not measured that starts when a gate pulse starts and has a duration that is greater than the duration of the gate pulse so that it covers the period of transient behaviour at the end of the gate pulse. If a series of two or more gate pulses are applied to a thyristor, a blanking time may start when an initial gate pulse starts, and the blanking time may have a duration that is greater than the duration of the series of gate pulses so that it covers the period of transient behaviour at the end of the final gate pulse in the series of gate pulses. Using a blanking time, which starts when a gate pulse starts and which has a particular duration, may be preferable to using a delay time that starts at the end of a gate pulse.

The duration of the blanking time may be set by a configurable integrated circuit of each gate drive unit, for example, and may depend on the duration of the gate pulse or series of gate pulses. The duration of the delay time may also be set by a configurable integrated circuit of each gate drive unit, for example.

Each gate drive unit may be adapted to measure the gate voltage of the respective thyristor using a filter. Any suitable filter may be used such as a digital filter, optionally implemented using the programmable logic device or digital signal processor of each gate drive unit, or an analog filter circuit, for example. Using a filter may avoid the need to wait for a period of time after the end of the applied gate pulse before the first gate voltage measurement is taken. In other words, it may be possible to take gate voltage measurements as soon as the applied gate pulse has ended without the need for any further delay time because there is no need to wait for the gate voltage to stabilise. Any suitable digital filter may be used, e.g., a moving average filter, low pass filter, band pass filter, finite impulse response filter etc. Any suitable analog filter may be used, including both passive and active filters. Each analog filter that may include electronical components such as one or more resistors, capacitors, inductors and, in the case of an active filter, operational amplifiers, for example. Each analog filter may be implemented as part of the respective gate drive unit and may be electrically connected between the gate drive terminal of the respective thyristor and the respective voltage sensor. Alternatively, each analog filter may be implemented as part of the respective voltage sensor.

The gate voltage of each thyristor may continue to be measured either continuously or periodically until the start of a subsequent gate pulse. If two or more measurements of the gate voltage are taken by each gate drive unit, information about the rate of change of the gate voltage of the respective thyristor may be determined or derived from the gate voltage measurements. Two or more gate voltage measurements may also be used to determine an average gate voltage measurement that may be compared against a voltage threshold - see below. Using an average gate voltage measurement instead of a single gate voltage measurement may provide a more accurate determination if the gate voltage has not yet stabilised fully after the end of the gate pulse.

The controller may be adapted to determine that a thyristor has not been triggered if the measured gate voltage of the thyristor is below a voltage threshold. The voltage threshold may be in the range of about 0.5 to about 1.5 volts, for example, shortly after the end of the blanking or delay time. It therefore follows that if the gate voltage is above the voltage threshold, the thyristor has been triggered by the gate pulse(s) and current is flowing through the thyristor. The voltage threshold for each thyristor may be set by the configurable integrated circuit of the respective gate drive unit or by the controller, for example. Each gate drive unit may be adapted to determine that the respective thyristor has not been triggered if the measured gate voltage of the thyristor is below a voltage threshold. If the triggering detection is carried out by the gate drive units, instead of the gate drive units providing gate voltage measurement signals to the controller, each gate drive unit may provide a signal to the controller that indicates if the respective thyristor has been triggered or has not been triggered, e.g., a trigger status or trigger detection signal. The controller may use such a signal to control the electric circuit (or the power converter, if applicable) or to control a gate drive unit to apply one or more further gate pulses to a thyristor that has not been triggered - see below.

The controller or the gate drive units may be adapted to apply one or more further gate pulses to a thyristor that has been determined not to have been triggered. In other words, if the gate pulse(s) already applied to the thyristor have not triggered the thyristor, one or more further gate pulses may be generated and applied by the gate drive unit to the gate terminal in a further attempt to trigger the thyristor. If a thyristor that is previously determined not to have been triggered is subsequently triggered by applying one or more further gate pulses, this may improve current symmetry and maximise power output. It will also unload those thyristors of the electric circuit that were already triggered and conducting current.

This might be done multiple times with the gate voltage being measured after the gate pulse (or the final gate pulse in a series of gate pulses) has ended. The controller or each gate drive unit may be adapted to count how many attempts are made to trigger a thyristor. The controller or each gate drive unit may be adapted to determine that there is a triggering fault with a thyristor if the thyristor has not been triggered a pre-defined number of times - i.e., if the measured gate voltage has been found to be below the voltage threshold a pre-defined number of times. It will be understood that if a thyristor consistently fails to trigger even after multiple attempts have been made, the controller or respective gate drive unit should be able to determine that there is a triggering fault with the thyristor. That thyristor may eventually need to be replaced or repaired.

If a triggering fault has been identified with a thyristor, the electric circuit may continue to operate if the other thyristors are triggering properly. But if multiple thyristors are not triggering it may be necessary to stop operation of the electric circuit for safety reasons. The controller may therefore be adapted to stop operation of the electric circuit if it determines that there is a triggering fault with a pre-defined number of thyristors. The pre-defined number of thyristors may depend on the topology of the electric circuit - e.g., on the total number of thyristors that are electrically connected in parallel or series. The pre-defined number of thyristors may correspond to a pre-defined redundancy level for the electric circuit, for example.

As well as being used to detect if a thyristor has not been triggered, the measured gate voltage of each thyristor may be used to control the generation of the gate pulses by the gate drive units. Parallel-connected thyristors will normally be triggered at substantially the same time. In other words, the gate pulses that are applied to the thyristors will normally be synchronised so that the gate pulses start at substantially the same time and have substantially the same duration. The controller may be adapted to shift or offset the start of each gate pulse applied to a thyristor (e.g., with respect to the start of the gate pulses applied to the other thyristors) based on the measured gate voltage of the thyristor. This may be applied to all of the thyristors in the electric circuit and may result in the gate pulses that are applied to each thyristor starting at slightly different times. The shift in the gate pulses for each thyristor will depend on the absolute value of the measured gate voltages. For example, if three parallel-connected thyristors have different gate voltages, a different shift or offset may be applied to their respective gate pulses so that their respective gate pulses start at different times and not at substantially the same time. The gate pulses applied to the three thyristors will, however, normally have the same pulse duration. Shifting the start of the gate pulses based on the measured gate voltages may improve current symmetry and avoid uneven current distribution during triggering of the thyristors. In one arrangement, the gate voltage of each thyristor may be measured during an initial operation of the electric circuit (e.g., on start-up) and then used to shift the start of the gate pulses that are applied to each thyristor during subsequent operation. In other words, the respective start times of the gate pulses applied to the thyristors are shifted once based on the initial measurements of the gate voltage to improve current symmetry etc. and this shift or offset is maintained during the subsequent operation of the electric circuit. Subsequent gate voltage measurements may be used to determine if a particular thyristor has not triggered properly, e.g., by comparing the measured gate voltage against a voltage threshold as described above. In another arrangement, the gate voltage of each thyristor may be measured after the end of each gate pulse (or after a series of two or more gate pulses) and then used to shift the start of the subsequent gate pulse (or each gate pulse in a series of subsequent gate pulses). The respective start time of the gate pulses that are applied to the thyristors may therefore be shifted continuously during the operation of the electric circuit, e.g., if the measured gate voltage of a thyristor changes over time.

The current distribution may be improved by shifting the gate pulses that are applied to the thyristors. The gate voltages of all of the parallel-connected thyristors may be measured at a particular time point, which may be determined by a control signal that is supplied to each gate drive unit by a controller. The measured gate voltages may be supplied to the controller. The average value of the measured gate voltages may be determined (e.g., by the controller) and the signed deviation of the individual gate voltages compared to the average value may be determined. The deviation of the gate voltage of the individual thyristors from the average value provides information about the symmetry of the thyristor current. For a negative deviation of a measured gate voltage compared to the average value it may be assumed that the current of the respective thyristor is lower than the mean of the thyristor currents. For a positive deviation of a measured gate voltage compared to the average value it may be assumed that the current of the respective thyristor is higher than the mean of the thyristor currents. (An idealised direct proportionality between gate voltage and thyristor current may be assumed.) For thyristors with a positive deviation, the gate pulses may be slightly delayed which means that the current in those thyristors will start to flow slightly later than would otherwise be the case. This means that the current amplitude will be slightly lower than if the gate pulses are applied without any time delay. For thyristors with a negative deviation, the gate pulses may be slightly advanced which means that the current in those thyristors will start to flow slightly earlier than would otherwise be the case. This is application for firing angles greater than zero. This means that the current amplitude will be slightly higher than if the gate pulses are applied without any time advance. The outlined method would also work by delaying gate pulses, which may often be preferred for simplicity. In this way, electrical differences between the individual parallel-connected thyristors which may be a result of different parasitic inductances, resistances or other electrical characteristics of the thyristors may be balanced by shifting the start of the gate pulses. Shifting the start of the gate pulses for the thyristors may be applied as an iteration process and several adjustment steps may be carried out until the positive and negative deviations of the measured gate voltages are within a certain limit or tolerance threshold of the mean value. If a certain limit or tolerance threshold cannot be reached by shifting the gate pulses, a maximum shift may be used to stop the iteration process. The maximum shift may be in the range of about 1-2 ms, for example. Alternatively, one of the measured gate voltages (e.g., the lowest gate voltage) may be used as a starting point for the iterative process instead of the average value. In this case, the gate pulses of the remaining thyristors are shifted (e.g., delayed) until the deviations of the measured gate voltages are within a certain limit or tolerance threshold. Linear scaling may be used so that the deviation of the measured gate voltage compared to the average value or the lowest value, for example, corresponds to a linearly scaled shift. Alternatively, a control loop with proportional and integral terms (e.g., PI controller) may be used to determine the respective shift. The specified limits for the gate voltage may correspond to the best possible achievable symmetry of the thyristor currents, which allows tolerances in the measurement with regard to the instantaneous values, time and any power converter system given by asymmetries in the hardware design. A typical limit for the thyristor currents and/or gate voltages may be 2.5%, 5% or 10%, for example. The process outlined above may be carried out during start-up of a power converter system or during initial commissioning, e.g., in the routine or factory testing, and prepared as an offline method. Shifts in the gate pulses may also be determined using current measurements. The specific shifts are then stored, for example in a table and used during operation. The process may also be applied as an online method before each start-up or during operation of a power converter system.

The present invention further provides a triggering detection method for an electric circuit comprising a plurality of electrically connected thyristors, the method comprising:
applying one or more gate pulses to a gate terminal of each thyristor; and
measuring the gate voltage of at least one thyristor after a period of time has elapsed following the end of an applied gate pulse.

The method may further comprise measuring the gate voltage of each thyristor after one or more gate pulses have been applied to each thyristor.

The method may further comprise using the measured gate voltage of each thyristor to estimate or determine the instantaneous current flowing through the respective thyristor. The relationship between the measured gate voltage and the thyristor current may ideally be directly proportional across a particular range of gate voltages that may be known and stored in a look-up table similar. The relationship may be determined during initial commissioning, e.g., in the routine or factory testing.

The gate voltage of each thyristor is measured after a period of time has elapsed following the end of an applied gate pulse. As described above, this means that the gate voltage is measured when transient behaviour following the end of the gate pulse has stopped.

The method may further comprise determining that a thyristor has not been triggered if the measured gate voltage is below a voltage threshold.

The method may further comprise shifting the start of a gate pulse applied to a thyristor (e.g., with respect to the start of the gate pulses applied to the other thyristors) based on the measured gate voltage of the thyristor.

### Drawings

Figure 1A is a schematic diagram of a first power converter system with a power converter operating as a rectifier;
Figure 1B is a schematic diagram of a second power converter system with a power converter operating as an inverter;
Figure 1C is a schematic diagram of a crowbar circuit with a delta configuration;
Figure 1D is a schematic diagram of a crowbar circuit with a star configuration.
Figure 2 is a schematic diagram of an electric circuit according to the present invention with a plurality of parallel-connected thyristors that may be used to implement a semiconductor switch of the power converter systems of Figures 1A and 1B or the crowbar circuits of Figures 1C and 1D;
Figure 3 is a waveform diagram showing thyristor current and gate current and gate voltage when a gate pulse is applied to a thyristor;
Figures 4 and 5 are flow diagrams showing a triggering detection method according to the present invention;
Figure 6 is a waveform diagram showing thyristor current for an electric circuit with two parallel-connected thyristors where additional gate pulses are applied to one of the thyristors;
Figure 7 is a waveform diagram showing thyristor current for an electric circuit with six parallel-connected thyristors where additional gate pulses are applied to one of the thyristors;
Figure 8 is a schematic diagram of an electric circuit according to the present invention with a plurality of parallel-connected thyristors that may be used to implement a semiconductor switch of the power converter systems of Figures 1A and 1B or the crowbar circuits of Figures 1C and 1D showing how the start of the gate pulses may be shifted;
Figure 9 is a waveform diagram showing thyristor current for six parallel-connected thyristors with shifted gate pulses; and
Figure 10 is a schematic diagram of one of the gate drive units of the electric circuit of Figure 2 showing a filter circuit.

### Specific description

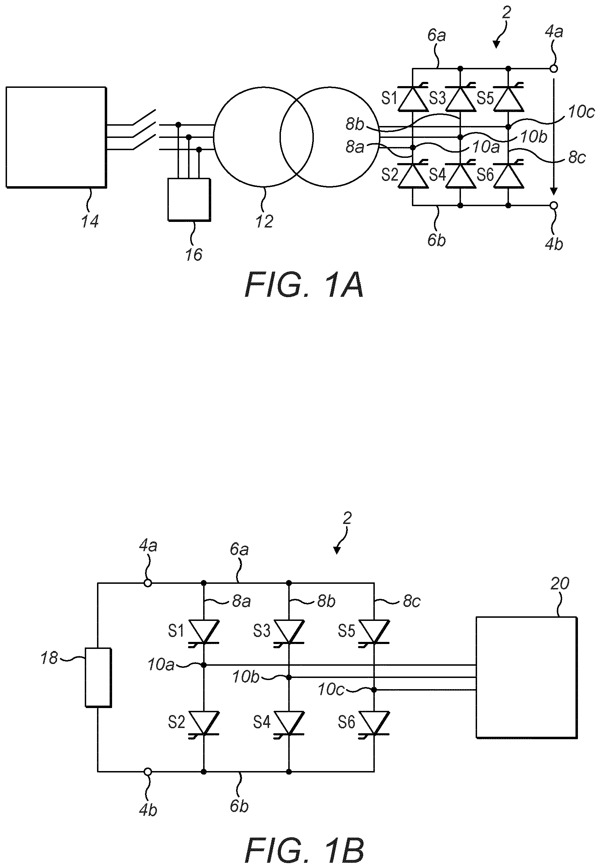

Referring to Figure 1A, a power converter 2 includes a pair of direct current (DC) terminals 4a, 4b electrically connected to a pair of DC rails 6a, 6b. A first converter leg 8a is electrically connected between the DC rails 6a, 6b and includes a first semiconductor switch S1 and a second semiconductor switch S2. The first converter leg 8a includes a first alternating current (AC) terminal 10a. A second converter leg 8b is electrically connected between the DC rails 6a, 6b and includes a third semiconductor switch S3 and a fourth semiconductor switch S4. The second converter leg 8b includes a second AC terminal 10b. A third converter leg 8c is electrically connected between the DC rails 6a, 6b and includes a fifth semiconductor switch S5 and a sixth semiconductor switch S6. The third converter leg 8c includes a third AC terminal 10c.

The AC terminals 10a, 10b and 10c are electrically connected to transformer 12, in particular to a secondary winding thereof. A primary winding of the transformer 12 is electrically connected to an AC power source 14. A filter 16 is electrically between the primary winding of the transformer and the power source 14.

The semiconductor switches S1, S2, ..., S6 may be turned on and off by a controller (not shown in Figure 1A) to convert the AC power at the AC terminals 10a, 10b and 10c of the power converter 2 to DC power at the DC terminals 4a, 4b in a known manner. In other words, the power converter 2 is normally operated as an active rectifier.

Referring to Figure 1B, the power converter 2 may be normally operated as an inverter. The DC terminals 4a, 4b are electrically connected to a DC power source 18 and the AC terminals 10a, 10b and 10c of the power converter 2 are electrically connected to an AC load 20. The semiconductor switches S1, S2, ..., S6 may be turned on any off by a controller (not shown in Figure 1B) to covert the DC power at the DC terminals 4a, 4b of the power converter 2 to AC power at the AC terminals 10a, 10b and 10c in a known manner.

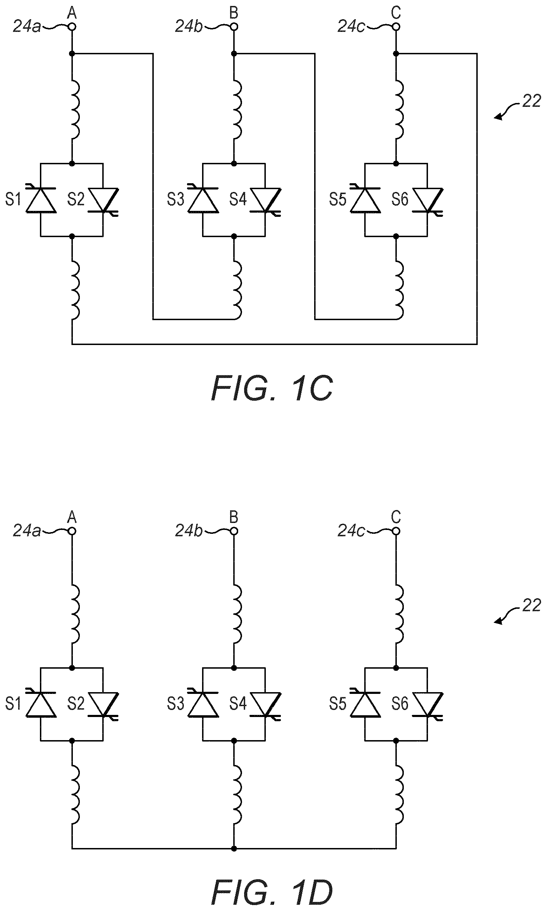

Referring to Figures 1C and 1D, a crowbar circuit 22 is electrically connected to AC terminals 24a, 24b and 24c. Each crowbar circuit 22 includes a first pair of switches S1 and S2 electrically connected to a first AC terminal 10a, a second pair of switches S3 and S4 electrically connected to a second AC terminal 10b, and a third pair of switches S5 and S6 electrically connected to a third AC terminal 10c. The crowbar circuit 22 shown in Figure 1C has a delta configuration and the crowbar circuit 22 shown in Figure 1D has a star configuration.

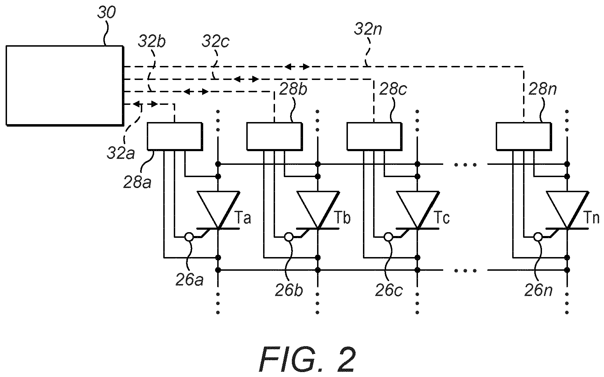

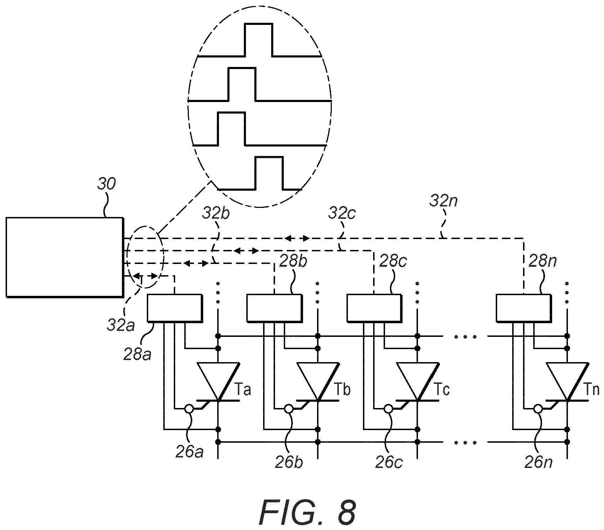

Each of the semiconductor switches S1, S2, ..., S6 may comprise a plurality of thyristors electrically connected in parallel. Figures 2 and 8 show an electric circuit according to the present invention with a plurality of parallel-connected thyristors Ta, Tb, ..., Tn, where n is any suitable integer. The parallel-connected thyristors Ta, Tb, ..., Tn may be used to implement one of the semiconductor switches S1, S2, ..., S6 of the power converter 2 shown in Figures 1A and 1B or the crowbar circuits 22 shown in Figures 1C and 1D.

Each thyristor Ta, Tb, ..., Tn has a gate terminal 26a, 26b, ..., 26n electrically connected to a respective gate drive unit 28a, 28b, ..., 28n as shown in Figures 2 and 8. Each gate drive unit 28a, 28b, ..., 28n is adapted to generate gate pulses for triggering the respective thyristor Ta, Tb, ..., Tn.

Each gate drive unit 28a, 28b, ..., 28n is also adapted to measure the gate voltage of the respective thyristor Ta, Tb, ..., Tn after one or more gate pulses have been applied to the respective thyristor. The gate voltage of each thyristor Ta, Tb, ..., Tn may be measured using a suitable voltage sensor (not shown) that is part of each gate drive unit 28a, 28b, ... 28n.

The gate drive units 28a, 28b, ..., 28n are controlled by a controller 30 and receive control signals from the controller for generating the gate pulses. The control signals are used by each gate drive unit 28a, 28b, ..., 28n to determine the start and duration of each gate pulse that is applied to the respective thyristor Ta, Tb, ..., Tn. The controller 30 also receives gate voltage measurement signals from the gate drive units 28a, 28b, ..., 28n. The control signals and the gate voltage measurement signals are transmitted using any suitable protocol and in Figures 2 and 8 are represented by the dashed lines 32a, 32b, ..., 32n.

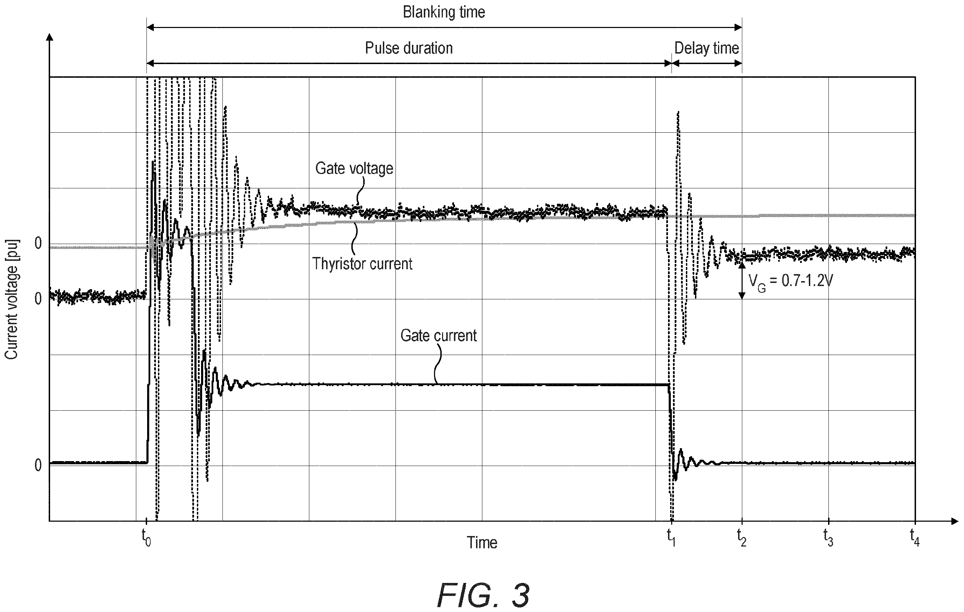

Each gate drive unit 28a, 28b, ..., 28n may be adapted to measure the gate voltage of the respective thyristor after a period of time has elapsed following the end of an applied gate pulse. In other words, after a gate pulse has ended, and the gate current has returned to zero, there may be a deliberate delay before the gate voltage is measured. Figure 3 shows the thyristor current, the gate current, and the gate voltage when a gate pulse is being applied to one of the thyristors (e.g., thyristor Ta). The duration of the gate pulse (labelled "pulse duration") is the time between the start of the gate pulse (i.e., time t₀) and the end of the gate pulse (i.e., time ti). This is when a gate current is being applied to the gate terminal of the thyristor. As can be seen in Figure 3, the gate voltage experiences transient behaviour at the start and end of the gate pulse (i.e., around times t₀ and ti). The gate voltage may be measured at time t₂, for example. The delay after the end of the gate pulse (labelled "delay time") allows the gate voltage to stabilise before it is measured. The gate pulse shown in Figure 3 may be the final gate pulse in a series of two or more gate pulses.

As an example, in Figure 3, the measured gate voltage V_{G} is shown to be in the range of about 0.7-1.2 volts.

The delay may be considered in terms of a period of time (labelled "blanking time") during which the gate voltage is not measured. The blanking time starts when a gate pulse starts and has a duration that is greater than the duration of the gate pulse so that it covers the period of transient behaviour at the end of the gate pulse. Figure 3 shows a blanking time that starts when the gate pulse starts (i.e., at time t₀) and ends at time t₂. But if the gate pulse is the final gate pulse in a series of two or more gate pulses, the blanking time may start at the start of the first gate pulse of the series of gate pulses - at an earlier time than what is shown in Figure 3.

After the delay, one or more measurements of the gate voltage may be taken. For example, after being measured at time t₂, the gate voltage may also be measured at times t₃, t₄ etc. The additional measurements may provide information about the rate of change of the gate voltage.

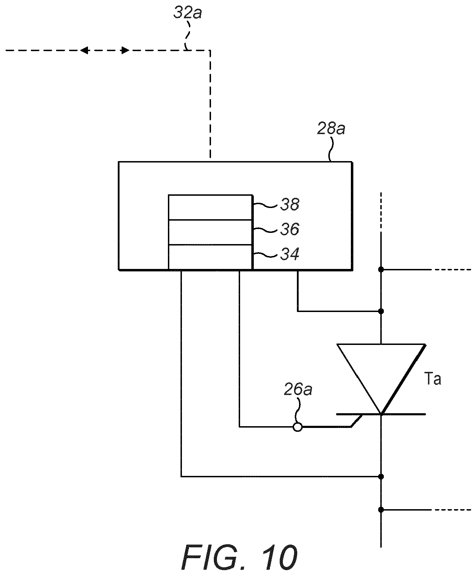

The gate drive units 28a, 28b, ..., 28n may be adapted to measure the gate voltage of the respective thyristor using a filter. Using a filter may avoid the need to wait for a period of time after the end of the applied gate pulse before the first gate voltage measurement is taken. In other words, it may be possible to take gate voltage measurements as soon as the applied gate pulse has ended without the need for any further delay time because there is no need to wait for the gate voltage to stabilise. Figure 10 shows an example where the gate drive unit 28a includes an analog filter 34, an analog-to-digital converter (or ADC) 36, and a programmable logic device 38. The other gate drive units 28b, 28c, ..., 28n will be implemented in the same way.

The controller 30 (or alternatively, the respective gate drive unit) determines that a thyristor has not been triggered if the measured gate voltage of the thyristor is below a voltage threshold. For example, if the measured gate voltage of thyristor Ta is below a voltage threshold, the controller 30 or the gate drive unit 28a will determine that this thyristor has not been triggered (i.e., has not been turned on) by the gate pulse(s) applied by the gate drive unit 28a. It therefore follows that if the gate voltage is above the voltage threshold, thyristor Ta has been triggered by the gate pulse(s) and current is flowing through thyristor Ta. As an example, the voltage threshold may be about 0.5 and about 1.5 volts shortly after the gate pulse has been turned off. For example, the voltage threshold may be in this range for about 5-100 µs after the end of the delay time or blanking time.

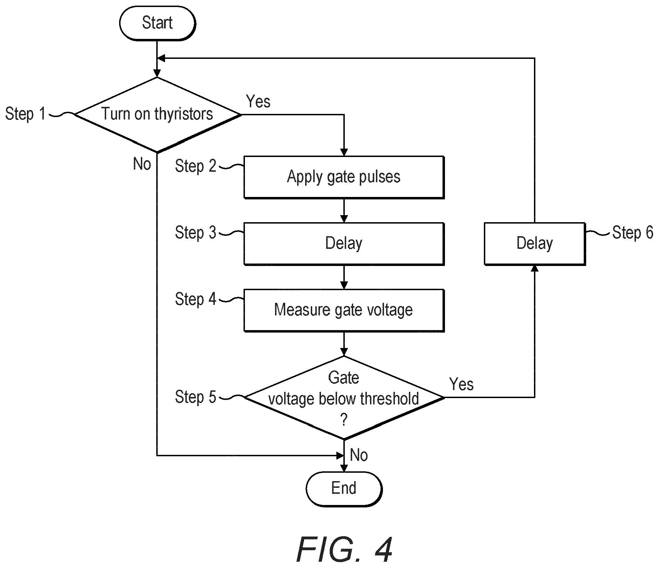

The controller 30 or the respective gate drive unit may be adapted to apply one or more further gate pulses to a thyristor that has been determined not to have been triggered. For example, if the controller 30 or the gate drive unit 28a determines that thyristor Ta has not been triggered (e.g., because the measured gate voltage is less than the voltage threshold), the gate drive unit 28a may be controlled to generate one or more further gate pulses and apply these to thyristor Ta in a further attempt to trigger it. Figure 4 shows a flow diagram of a method for detecting triggering of a thyristor. If the thyristors Ta, Tb, ..., Tn are to be turned on (Step 1) a series of gate pulses are generated by the gate drive units 28a, 28b, ..., 28n and applied to the respective thyristors Ta, Tb, ..., Tn. In this cases, a series of gate pulses are generated by the gate drive unit 28a and applied to thyristor Ta (Step 2). After the final gate pulse in the series of gate pulses has been applied to thyristor Ta there is a delay (Step 3) which may be determined by a delay time that starts when the final gate pulse ends, or a blanking time that starts when the first gate pulse starts, after which the gate voltage of thyristor Ta is measured (Step 4) by a voltage sensor of the gate drive unit 28a. The controller 30 determines if the measured gate voltage is below a voltage threshold (Step 5). If the measured gate voltage is above the voltage threshold, the method ends. But if the measured gate voltage is below the voltage threshold, which means that thyristor Ta has not been triggered, there is a delay (Step 6) after which a further series of gate pulses are generated by the gate drive unit 28a and applied to thyristor Ta. Further gate pulses may be generated and applied to thyristor Ta for as long as the thyristors Ta, Tb, ..., Tn are to be turned on (Step 1). The determination of whether or not the measured gate voltage is above or below the voltage threshold may alternatively be made by the gate drive unit 28a.

The triggering of the remaining thyristors Tb, Tc, ..., Tn may be determined by the controller 30 in the same way and further gate pulses may be generated by the gate drive units 28b, 28c, ..., 28n if necessary.

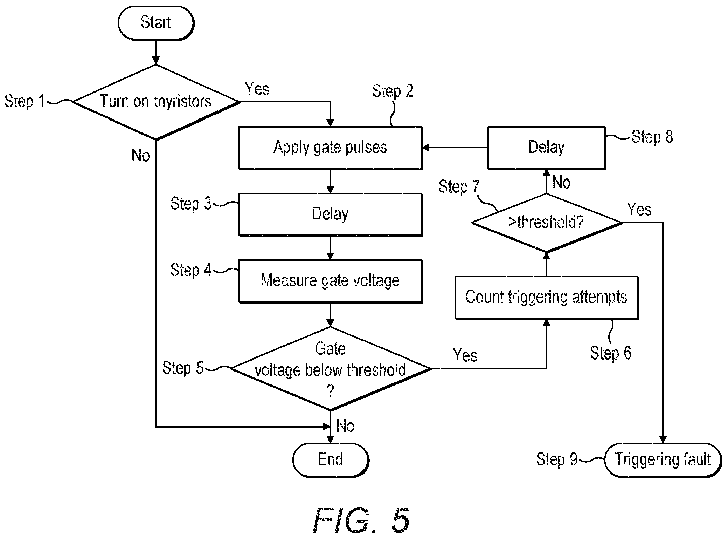

Figure 5 shows a flow diagram of an alternative method for detecting triggering of a thyristor. In this alternative method, if the measured gate voltage is below the voltage threshold, which means that thyristor Ta has not been triggered, for example, the number of triggering attempts is counted (Step 6). For example, this may be done by setting a count to an initial value at the start of the method and increasing the count by one each time the gate voltage of thyristor Ta is determined to be below the voltage threshold. If the number of triggering attempts is less than or equal to a threshold (Step 7) there is a delay (Step 8) after which a further series of gate pulses are generated by the gate drive unit 28a and applied to thyristor Ta. However, if the number of triggering attempts is greater than a threshold, the controller 30 determines that there is a triggering fault (Step 9) with thyristor Ta and no further attempt to trigger it is made. In this case, thyristor Ta may eventually need to be replaced or repaired.

The triggering of the remaining thyristors Tb, Tc, ..., Tn may be determined by the controller 30 in the same way and further gate pulses may be generated by the gate drive units 28b, 28c, ..., 28n if necessary. If the number of triggering attempts is greater than a threshold, the controller 30 determines that there is a triggering fault with one of the remaining thyristor Tb, Tc, ..., Tn and no further attempt to trigger it is made. In this case, the faulty thyristor may eventually need to be replaced or repaired.

If a triggering fault has been identified with a thyristor, the electric circuit may continue to operate if the other thyristors are triggering properly. But if multiple thyristors are not triggering it may be necessary to stop operation of the electric circuit for safety reasons. The controller 28 may therefore be adapted to stop operation of the electric circuit (or the power converter 2) if it determines that there is a triggering fault with a pre-defined number of thyristors.

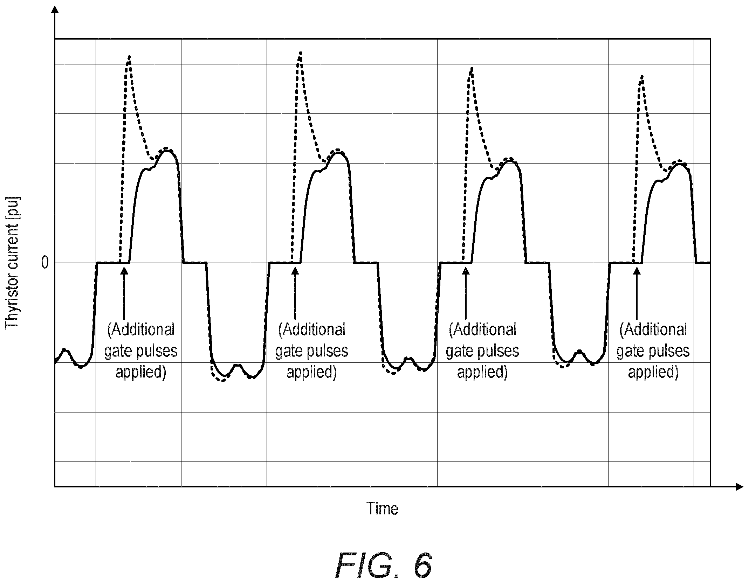

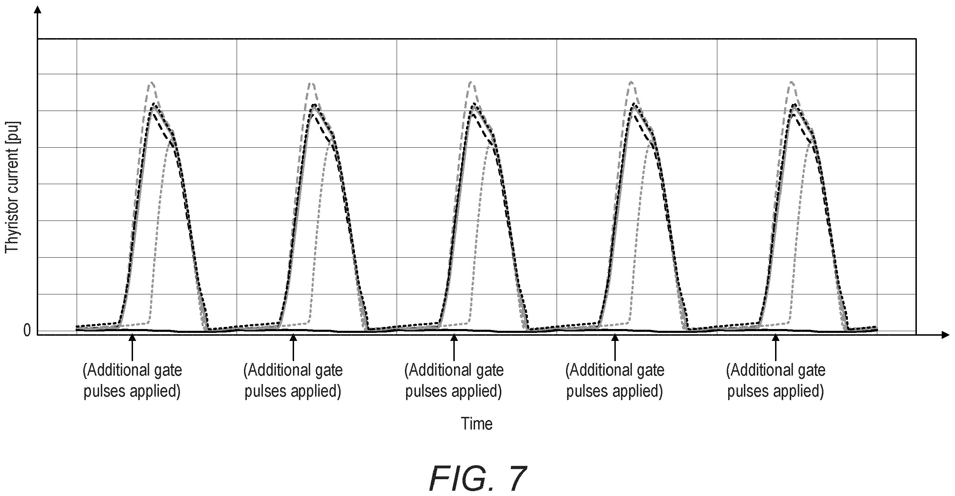

Figures 6 and 7 show thyristor current waveforms for electric circuits with two and six parallel-connected thyristors, respectively. In both cases, one of the thyristors is triggered late by applying one or more further gate pulses. This improves thyristor current symmetry and Figures 6 and 7 show how the one or more previously-conducting thyristors are unloaded.

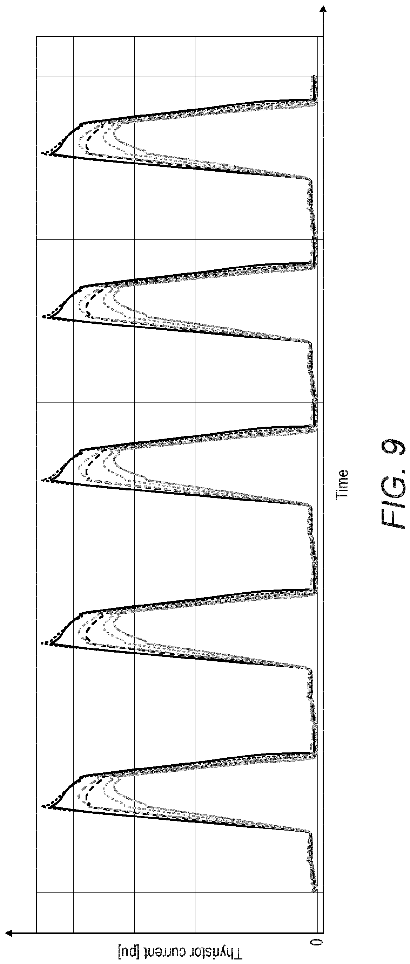

As well as being used to detect if a thyristor has not been triggered, the measured gate voltage of each thyristor Ta, Tb, ..., Tn may be used to control the generation of the gate pulses by the gate drive units 28a, 28b, ..., 28n. Parallel-connected thyristors will normally be triggered at substantially the same time. In other words, the gate pulses that are applied to the thyristors Ta, Tb, ..., Tn will normally be synchronised so that the gate pulses start at substantially the same time and have substantially the same duration. Figure 8 shows how the controller 30 may be adapted to shift or offset the start of each gate pulse applied to each thyristor Ta, Tb, ..., Tn based on the measured gate voltage of each thyristor. In particular, Figure 8 shows how the control signals 32a, 32b, ..., 32n applied to the gate drive units 28a, 28b, ..., 28n may be offset so that the gate pulses that are applied to the thyristors Ta, Tb, ..., Tn start at slightly different times. The shift in the gate pulses for each thyristor Ta, Tb, ..., Tn will depend on the absolute value of the measured gate voltages. The gate pulses applied to the thyristors Ta, Tb, ..., Tn will, however, normally have the same pulse duration. Shifting or offsetting the start of the gate pulses based on the measured gate voltages may improve current symmetry and avoid uneven current distribution during triggering of the thyristors Ta, Tb, ..., Tn. This current symmetry is shown in Figure 9.

The gate voltage of each thyristor Ta, Tb, ..., Tn may be measured after the end of each gate pulse (or after a series of two or more gate pulses) and then used to shift the start of the subsequent gate pulse (or each gate pulse of a series of subsequent gate pulses) applied by the gate drive units 28a, 28b, ..., 28n. The respective start time of the gate pulses that are applied to the thyristors Ta, Tb, ..., Tn may therefore be shifted continuously during the operation of the electric circuit, e.g., if the measured gate voltage of a thyristor changes over time.

## Claims

1. An electric circuit comprising:
a plurality of electrically connected thyristors (Ta, Tb, ..., Tn), each thyristor (Ta, Tb, ..., Tn) having a gate terminal (26a, 26b, ..., 26n) electrically connected to a respective gate drive unit (28a, 28b, ..., 28n) adapted to generate gate pulses for triggering the thyristor (Ta, Tb, ..., Tn);
wherein at least one of the plurality of gate drive units (28a, 28b, ..., 28n) is adapted to measure the gate voltage of the respective thyristor (Ta, Tb, ..., Tn) after one or more gate pulses have been applied to the gate terminal (26a, 26b, ..., 26n) of the respective thyristor (Ta, Tb, ..., Tn).

2. An electric circuit according to claim 1, wherein the thyristors (Ta, Tb, ..., Tn) are electrically connected in parallel.

3. An electric circuit according to claim 1 or claim 2, wherein each gate drive unit (28a, 28b, ..., 28n) is adapted to measure the gate voltage of the respective thyristor (Ta, Tb, ..., Tn) after one or more gate pulses have been applied to the respective thyristor (Ta, Tb, ..., Tn).

4. An electric circuit according to any preceding claim, wherein the at least one gate drive unit is adapted to measure the gate voltage of the respective thyristor after a period of time has elapsed following the end of an applied gate pulse, wherein the period of time is optionally at least 1 µs.

5. An electric circuit according to any preceding claim, wherein the at least one gate drive unit is adapted to measure the gate voltage of the respective thyristor using a filter, e.g., a digital filter or a filter circuit (34).

6. An electric circuit according to any preceding claim, wherein each gate drive unit (28a, 28b, ..., 28n) is adapted to take two or more measurements of the gate voltage of the respective thyristor after one or more gate pulses have been applied to the respective thyristor (Ta, Tb, ..., Tn).

7. An electric circuit according to any preceding claim, further comprising a controller (30) that receives the measured gate voltage from each gate drive unit (28a, 28b, ..., 28n), wherein the controller (30) is adapted to determine that a thyristor has not been triggered if the measured gate voltage of the thyristor is below a voltage threshold, wherein the voltage threshold is optionally in the range of about 0.5 to about 1.5 volts.

8. An electric circuit according to claim 7, wherein the controller (30) is adapted to control the respective gate drive unit (28a, 28b, ..., 28n) to apply one or more further gate pulses to a thyristor (Ta, Tb, ..., Tn) that has been determined not to have been triggered.

9. An electric circuit according to claim 7 or claim 8, wherein the controller (30) is adapted to determine that there is a triggering fault with a thyristor (Ta, Tb, ..., Tn) if the controller (30) determines that the thyristor (Ta, Tb, ..., Tn) has not been triggered a pre-defined number of times.

10. An electric circuit according to claim 9, wherein the controller (30) is adapted to stop operation of the electric circuit if it determines that there is a triggering fault with a pre-defined number of thyristors (Ta, Tb, ..., Tn) of the electric circuit, wherein the pre-defined number of thyristors optionally corresponds to a pre-defined redundancy level.

11. An electric circuit according to any of claims 1 to 6, further comprising a controller (30) that receives the measured gate voltage from each gate drive unit (28a, 28b, ..., 28n), wherein the controller (30) is adapted to shift the start of each gate pulse applied to a thyristor based on the measured gate voltage of the thyristor.

12. A triggering detection method for an electric circuit comprising a plurality of electrically connected thyristors (Ta, Tb, ..., Tn), the method comprising:
applying one or more gate pulses to a gate terminal (26a, 26b, ..., 26n) of each thyristor (Ta, Tb, ..., Tn); and
measuring the gate voltage of at least one thyristor (Ta, Tb, ..., Tn).

13. A method according to claim 12, wherein the gate voltage of the at least one thyristor is measured after a period of time has elapsed following the end of an applied gate pulse.

14. A method according to claim 12 or claim 13, wherein the gate voltage of the at least one thyristor is measured using a filter.

15. A method according to any of claims 12 to 14, further comprising measuring the gate voltage of each thyristor (Ta, Tb, ..., Tn) after one or more gates pulse have been applied.

16. A method according to claim 15, further comprising using the measured gate voltage of each thyristor (Ta, Tb, ..., Tn) to estimate or determine the instantaneous current flowing through the respective thyristor (Ta, Tb, ..., Tn).

17. A method according to any of claims 12 to 16, further comprising determining that a thyristor (Ta, Tb, ..., Tn) has not been triggered if the measured gate voltage is below a voltage threshold, and optionally applying one or more further pulses to the non-triggered thyristor.

18. A method according to any of claims 12 to 17, further comprising shifting the start of each gate pulse applied to a thyristor (Ta, Tb, ..., Tn) based on the measured gate voltage of the thyristor.
